# EUROPEAN PATENT SPECIFICATION

(11) **EP 0 823 747 B1**
(45) Date of publication and mention of the grant of the patent: **03.03.2004**
(21) Application number: 97113702.1
(22) Date of filing: 07.08.1997
(51) Int. Cl.: H01P 5/04, H04B 1/12, H03H 7/20, H03F 1/32

(54) **RF phase and/or amplitude control device**
Hochfrequenzgerät zur Phasen- und/oder Amplitudenregelung
Dispositif radiofréquence de réglage de phase et/ou d'amplitude

(30) Priority: 07.08.1996 US 23525 P
(43) Date of publication of application: 11.02.1998
(73) Proprietor: Raytheon Company, Lexington, Massachusetts 02173 (US)
(72) Inventor: Kyle, Robert R., McKinney, TX 75070 (US); Meyer, Ronald L., Plano, TX 75093 (US); Dixon, William F., Flower Mound, TX 75028 (US)
(74) Representative: Degwert, Hartmut, Dipl.-Phys.

(56) References cited:
- US-A- 4 297 641
- US-A- 5 019 793
- US-A- 5 222 246
- US-A- 5 355 103

## Description

### TECHNICAL FIELD OF THE INVENTION

This invention relates to RF systems and more particularly to a digitally addressable RF control device for control of an RF signal as defined in the precharacterizing portion of claim 1.

### BACKGROUND OF THE INVENTION

Radio frequency signal (RF) phase and amplitude control devices are used in a wide range of applications such as communication systems, radar systems, antenna systems, etc. It is further highly desirable that these RF control devices used for phase and amplitude control be digitally addressable devices. These RF control devices may include ferrite devices (such as ferrite phase shifters, for example) or semiconductor devices. The ferrite devices are expensive and the performance is limited. Semiconductor devices such as varactors, PIN diodes, and transistors are temperature sensitive, and therefore, resolution limited. It is therefore highly desirable to provide a high resolution RF control device for control using low cost elements.

A system as defined in the precharacterizing portion of claim 1 is known from US-A-5,355,103. That documents discloses a fast settling, wide dynamic range vector modulator for use in an interference cancellation system or the like. A quadrature hybrid receives an RF signal and divides the signal into a primary in-phase component signal and a primary quadrature phase component signal. A first 180° hybrid receives the primary in-phase component signal and provides first and second secondary in-phase component signals which are 180° out of phase with each other. A second 180° hybrid receives the primary quadrature phase component signal and provides first and second secondary quadrature phase component signals which are 180° out of phase with each other. A first switching device selects one of the first and second secondary in-phase component signals, and a second switching device selects one of the first and second secondary quadrature phase component signals. First and second coarse attenuators respectively provide a selectable amount of attenuation to the selected in-phase and quadrature phase component signals. First and second fine attenuators provide fine attenuation to the coarse attenuated in-phase and quadrature phase component signals. A signal combiner combines the fine attenuated in-phase and quadrature phase component signals to provide the corresponding output signal.

Reference is further made to US-A-5,222,246, which discloses a power amplifier arrangement including a power divider for dividing the signal to be amplified into equal-amplitude components. Each component is amplified by a signal amplifying path. The amplified signals are applied to a phase-sensitive power combiner. The combined signal appears at the sum port and a phase-related difference signal appears at a difference port of the combiner. The difference signal is processed to produce a control signal for controlling the relative phases of the signals passing through the signal amplifying paths.

Finally, reference is made to US-A-4,297,641, which discloses an adjustable phase shifting circuit comprising first and second signal paths, each including an output terminal, an input terminal to which the frequency to be shifted is applied, and a variable level signal translating device with a level control terminal. Means are included for effecting a 90° phase shift in one signal path relative to the other and for producing a signal which is the vector sum of the signals appearing at the output terminals. A means is coupled to the control terminal of the variable level signal translating devices for respectively applying control signals to control the level of the signals produced at the output terminals for controlling the phase of the vector sum signal.

### SUMMARY OF THE INVENTION

In accordance with the present invention an improved RF control device for phase shifting and amplitude control of an RF signal is provided. The invention is defined by the features of claim 1. Further embodiments are defined in the dependent claims. This provides a single inexpensive device which can provide digitally controlled output signals which are phase controlled and amplitude controlled.

These and other features of the invention will be apparent to those skilled in the art from the following detailed description of the invention, taken together with the accompanying drawings.

### DESCRIPTION OF THE DRAWINGS

The present invention will now be further described, by way of example, with reference to the accompanying drawings in which:
Fig. 1 is a block diagram of an RF control device according to one embodiment of the present invention;
Fig. 2 is a graph of the settings for the device of Fig. 1 where the I path is represented by solid lines and Q path by dashed lines;
Fig. 3 illustrates the phase error using the attenuator setting of Fig. 2;
Fig. 4 illustrates the amplitude variation for the attenuator settings of Fig. 3;
Fig. 5 illustrates the distribution of phase errors for the results shown in Fig. 3;
Fig. 6 illustrates the vector magnitude error distribution for the results shown in Fig. 4; and
Fig. 7 shows the comparison of the digital processor calculated I and Q values with the values determined from an ideal weighter circuit.

### DESCRIPTION OF PREFERRED EMBODIMENTS OF THE PRESENT INVENTION

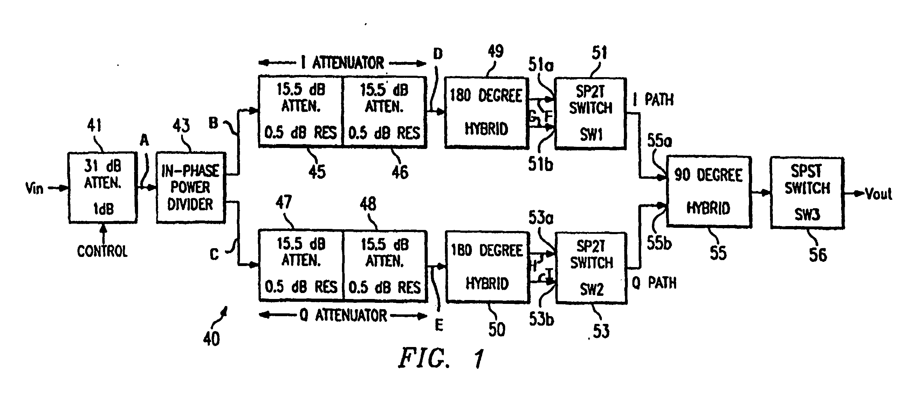

In accordance with an embodiment of the present invention there is provided an RF control device 40 as illustrated in Fig. 1. The RF control device includes an input variable attenuator 41 which is a step attenuator that attenuates in half dB increments from 0 to 31 dB. This attenuator 41 is digitally controlled having nine binary inputs. The attenuator 41 is implemented for example using two cascaded MA/COM AT280 attenuators each having a range of 15.5 dB in 0.5 dB steps. The attenuator 41 adjusts the overall output power level. The output (at A) from the attenuator 41 is power divided by an equal in-phase power divider 43 and applied separately to an I (at B) and a Q (C) path. The in-phase power divider is for example a MA/COM DS-327. A lower cost Wilkinson power divider may also be used. In this particular embodiment, the I path includes 15.5 dB attenuators 45 and 46 cascaded in series. Similarly the Q path has two 15.5 dB attenuators 47 and 48 cascaded in series. These attenuators 45-48 are also digitally controlled by binary inputs. They are also MA/COM T280 attenuators for example. These attenuators are low cost surface mount GaAs (Gallium Arsenide) attenuators. These attenuators can adjust the relative amplitudes of signals in the I and Q paths. The output at D and E are from the separate I and Q attenuators 46 and 48. The output at point D from attenuator 46 is applied to 180° hybrid 49 to produce two equal power (power divided) 180° out of phase shifted signals at 51a and 51b. This 180° hybrid 19 is, for example, MA/COM HH-128 hybrid. This hybrid 19 may also be made at a lower cost using a rat race hybrid in microstrip. Likewise, the output at point E from attenuator 48 is applied to 180° hybrid 50 to produce two equal power signals that are 180° out of phase at 53a and 53b. The hybrid 50 is also on MA/COM HH-128 hybrid, but may be a rat race hybrid. The selected output from points 51a or 51b in path I is applied by a single pole double throw switch 51 to a port 55a of a 90° hybrid 55. This switch, for example, is a MA/COM SW 29. Similarly, the selected output from points 53a or 53b in path Q is applied by single pole double throw switch 53 to the port 55b of 90° hybrid 55. This switch is also, for example, a MA/COM SW29. The 90° hybrid 55, for the example, is a MA/COM JH140. It may be made at a lower cost using a Lange microstrip hybrid coupler or branch line hybrid coupler. The outputs from the I path and the Q path are then combined through the 90° hybrid 55. The output is provided via SPST (single pole double throw switch 56).

The 180° hybrids 49 and 50 followed by SP2T switches 51 and 53 establish which quadrant the vector is in while the 90 degree hybrid, 55, vector combines the I and Q magnitudes orthogonally.

The mathematics of this vector weighter are summarized below and references are to locations shown on the block diagram of Fig. 1. At point A the value is *k*₁ **v*ᵢₙ where *k*₁ = 10^{(ATT1/20)}and ATT1 (41) is negative dB.
At points B and C,$\frac{{\text{k}}_{\text{1}} \text{*} {\text{v}}_{\text{in}}}{\sqrt{\text{2}}} \text{.}$
At point D,$\frac{{\text{k}}_{\text{1}} \text{*} {\text{k}}_{\text{2}} \text{*} {\text{v}}_{\text{in}}}{\sqrt{\text{2}}}$ where *k*₂ = 10^{((ATT2 + ATT3)/20)} and ATT2 (45) and ATT3 (46) are negative.
At point E,$\frac{{\text{k}}_{\text{1}} \text{*} {\text{k}}_{\text{3}} \text{*} {\text{v}}_{\text{in}}}{\sqrt{\text{2}}}$ where *k*₃ = 10^{((ATT4 + ATT5)/20)} and ATT4 (47) and ATT5 (48) are negative.
At point 51a(F),$\frac{{\text{k}}_{\text{1}} \text{*} {\text{k}}_{\text{2}} \text{*} {\text{v}}_{\text{in}}}{\text{2}} \text{.}$ At point 51b(G), -$\frac{{\text{k}}_{\text{1}} \text{*} {\text{k}}_{\text{2}} \text{*} {\text{v}}_{\text{in}}}{\text{2}} \text{.}$ .
At point 53a(H),$\frac{{\text{k}}_{\text{1}} \text{*} {\text{k}}_{\text{3}} \text{*} {\text{v}}_{\text{in}}}{\text{2}} \text{.}$ At point 53b(I), -$\frac{{\text{k}}_{\text{1}} \text{*} {\text{k}}_{\text{3}} \text{*} {\text{v}}_{\text{in}}}{\text{2}} \text{.}$ .
The selected outputs at point L out of hybrid 55 are: 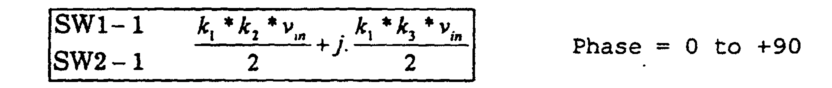 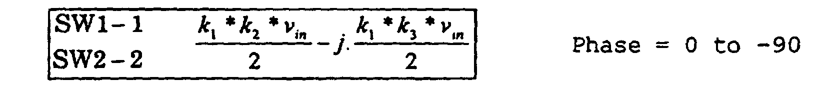 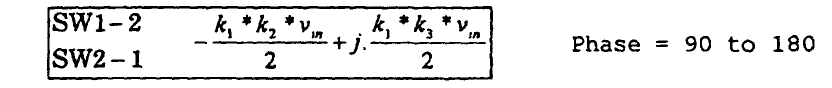 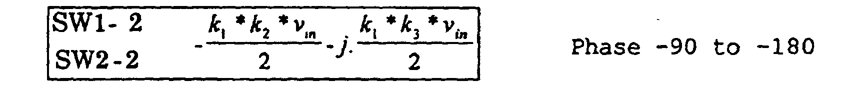 In general,${\text{v}}_{\text{out}} \text{=} \frac{{\text{v}}_{\text{in}} \text{*} {\text{k}}_{\text{1}}}{\text{2}} \text{·[±·} {\text{k}}_{\text{2}} \text{±} {\text{jk}}_{\text{3}} \text{].}$

An optimization strategy is one where $\sqrt{{\text{k}}_{\text{2}} {\text{}}^{\text{2}} \text{+} {\text{k}}_{\text{3}} {\text{}}^{\text{2}}}$is between 1 (0dB) and 1.059 (+0.5dB) for *k*₂ and *k*₃ varying from 0.02818(-31 dB) to 1(0dB) in 0.5 dB steps, then the ideal loss will be between -5.5 and -6 dB. The actual loss will be greater due to component losses.

The strategy is to minimize the vector magnitude variation with phase while allowing the minimum possible phase step size for 0.5 dB resolution attenuators. Such an algorithm was developed with the absolute minimum phase step size determined to be 0.8 degrees and the worst case magnitude variation equal to 0.5 dB. The 0.8 degrees step size corresponds to approximately 9 bit resolution.

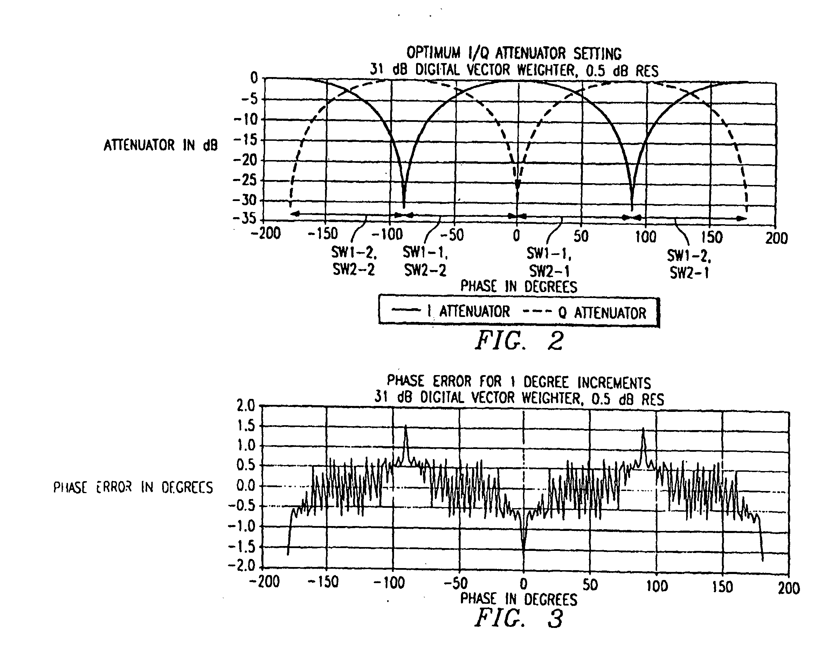

Fig. 2 is a graph of the optimum attenuator setting of ATT2 (45), ATT3 (46), ATT4 (47), and ATT5 (48) for phases from -180 to +180 in 1 degree increments. The switch settings are also shown on Fig. 2. In Fig. 2, SW1-2 is switch 51 providing 51b output, SW2-2 is switch 53 providing 53b output, SW1-1 is switch 51 providing 51a output and SW2-1 is switch 53 providing 53a output. The solid lines is for attenuator settings in path I and the dashed lines is for attenuator setting in path Q.

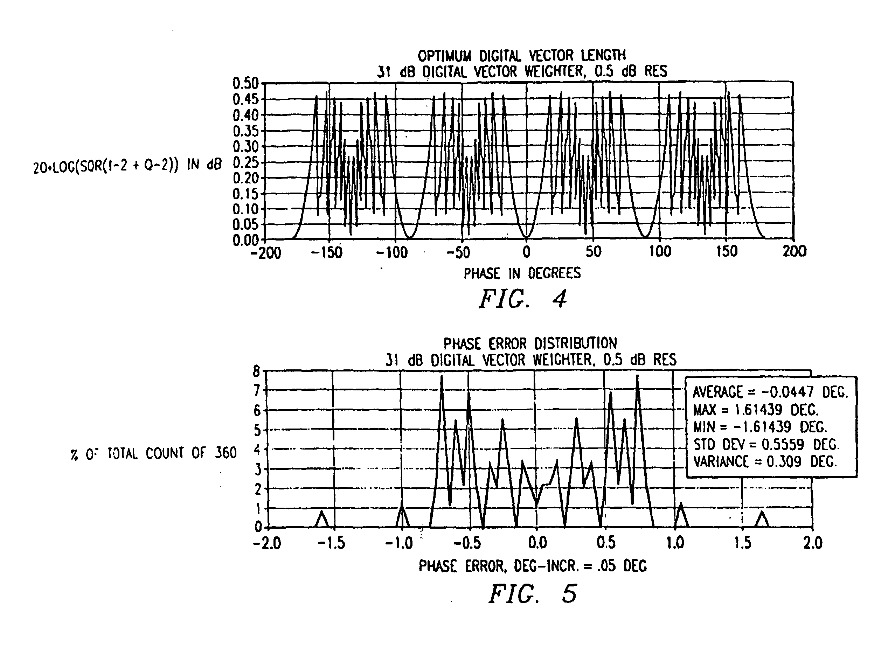

This device is optimized using two criteria. One was to realize the minimum phase error using 0.5 dB increment sizes of the I attenuators and Q attenuators and using the complete 31 dB range. The other optimization criteria was that the vector length have a maximum variation of 0.5 dB over 360 degrees. The phase error using the attenuator setting of Fig. 2 is shown in Fig. 3. The worst case errors of 1.61 degrees occurs at 0, 90, -90, and 180 degree points however, 96% of the errors are less than 0.8 degrees.

The amplitude variation of vector for the attenuator settings of Fig. 2 is shown in Fig. 4.

Fig. 5 shows the distribution of phase errors for the results shown in Fig. 3. From this graph, about 4% of the errors are greater than 1 degree with the maximum being 1.61 degrees. 96% of the errors are less than 0.8 degrees.

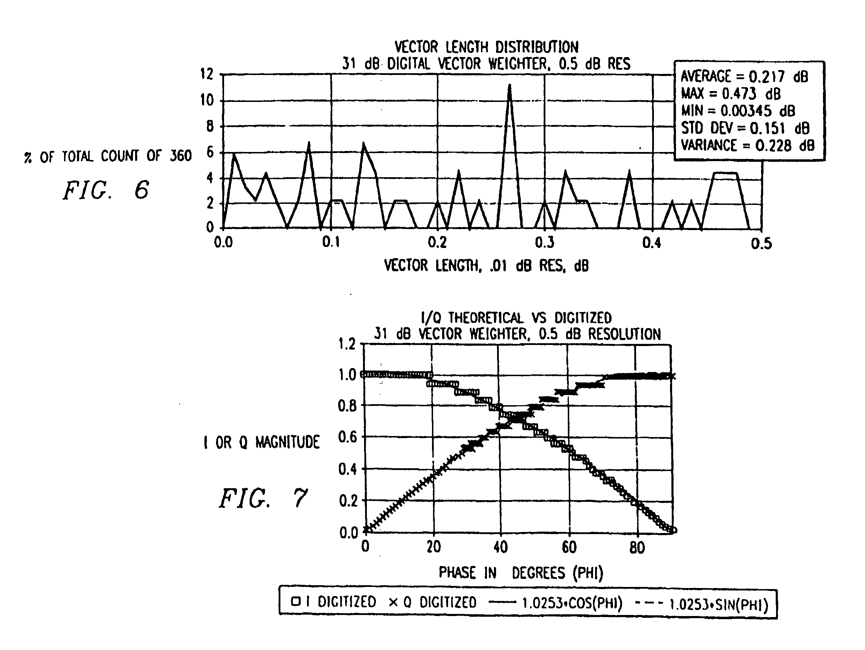

Fig. 6 shows the vector length magnitude error distributions for the results shown in Fig. 4. This shape suggests a uniform distribution of errors about the mean value of +0.217 dB (1.0253 magnitude) with a maximum error of + 0.235 dB about this mean value.

The digital processor will determine an RF phase (φ) value and an RF magnitude (*k*₁) value. The desired phase angle will be defined from an I and Q value. The vector magnitude will be established by one value, *k*₁.

The I and Q values will be calculated as follows.$\text{I = +1.0253 *} \text{COS} \text{(φ)}$$\text{Q = +1.0253 *} \text{SIN} \text{(φ)}$ where φ will be 0 to 90 degrees in 1 degree steps and
where the + or - sign will select the proper quadrant for φ. The vector magnitude will be determined from the following relationship. 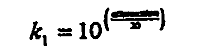 where attenuation will be from 0 to -31 dB.

A lookup table in RAM (Random Access Memory) will establish the corresponding address to the digital RF vector weighting circuit.

Fig. 7 shows the comparison of the digital processor calculated I and Q values with the values determined from the ideal vector weighter circuit.

Although the present invention and its advantages have been described in detail, it should be understood that various changes, substitutions and alterations can be made herein without departing from the scope of the invention.

## Claims

1. An RF control device for controlling both the amplitude and phase of an RF input signal, including:
an input divider circuit (43) operable to divide the RF input signal into first and second component signals;
a digitally controlled first component processing circuit operable to control the amplitude and phase of the first component signal in order to generate a first controlled component signal, said first component processing circuit including a digitally controlled first amplitude control circuit (45, 46) and a digitally controlled first phase control circuit (49, 51);
a digitally controlled second component processing circuit operable to control the amplitude and phase of the second component signal in order to generate a second controlled component signal, said second component processing circuit including a digitally controlled second amplitude control circuit (47, 48) and a digitally controlled second phase control circuit (50, 53);
a combiner circuit (55) for generating an output signal by combining the first and second controlled component signals, the output signal being an amplitude and phase controlled version of the RF input signal; and
a digital control circuit operable to effect digital control of said first and second component processing circuits in response to a desired amplitude and phase control for the input signal;
**characterized in that**:
said first amplitude control circuit (45,46) is operable to control the amplitude of the first component signal in order to generate a first amplitude controlled signal;
said first phase control circuit (49, 51) is operable to control the phase of the first amplitude controlled signal in order to generate said first controlled component signal;
said second amplitude control circuit (47, 48) is operable to control the amplitude of the second component signal in order to generate a second amplitude controlled signal;
said second phase control circuit (50, 53) is operable to control the phase of the second amplitude controlled signal in order to generate said second controlled component signal; and
said digital control circuit is operable to effect control of said amplitude and phase control circuits in response to said desired amplitude and phase control for the input signal, by supplying to each of said amplitude and phase control circuits predetermined digital control information which corresponds to the desired amplitude and phase control for the input signal.

2. An RF control device according to claim 1, wherein said first phase control circuit includes a first signal divider circuit (49) operable to divide the first amplitude controlled signal into first and second divided signals which are of opposite phase, and a digitally controlled first switch circuit (51) for selecting one of the first and second divided signals to be the first controlled component signal; and wherein said second phase control circuit includes a second signal divider circuit (50) operable to divide the second amplitude controlled signal into third and fourth divided signals which are opposite phase, and a digitally controlled second switch circuit (53) for selecting one of the third and fourth divided signals to be the second controlled component signal.

3. An RF control device according to claim 1 or claim 2, including a preliminary amplitude control circuit (41) for controlling the amplitude of the RF input signal in order to generate an attentuated RF input signal which is supplied to an input of the input divider circuit (43).

4. An RF control device according to any of claims 1 to 3, wherein said first and second amplitude control circuits each include a digitally controlled attenuator (45, 46, 47, 48).

5. An RF control device according to any of claims 2 to 4, wherein said input divider circuit (43) includes an in-phase power divider, wherein said first and second signal divider circuits (49, 50) each include a 180° hybrid, and wherein said combiner circuit (55) includes a 90° hybrid.

6. An RF control device according to claim 5, including a digitally controlled third switch circuit (56) coupled to the output of said 90° hybrid.

7. An RF control device according to any of claims 4 to 6, wherein said preliminary amplitude control circuit (41) includes a digitally controlled attenuator which has a 31 dB range and attenuates in steps of 1 dB, and wherein said digitally controlled attenuators (45, 46, 47, 48) of said first and second amplitude control circuits each include two series-coupled attenuators that each have a 15.5 dB range and each attenuate in steps of 0.5 dB.

## Patentansprüche

1. Hochfrequenzsteuergerät zur Steuerung sowohl der Amplitude als auch der Phase eines HF-Eingangssignals, das folgendes umfasst:
eine Eingangsteilerschaltung, die so betrieben werden kann, dass sie das HF-Eingangssignal in ein erstes und ein zweites Komponentensignal aufteilt;
eine digital gesteuerte erste Komponentenverarbeitungsschaltung, die so betrieben werden kann, dass sie die Amplitude und die Phase des ersten Komponentensignals steuern kann, um ein erstes gesteuertes Komponentensignal zu erzeugen, wobei die erste Komponentenverarbeitungsschaltung eine digital gesteuerte erste Amplitudensteuerschaltung (45, 46) umfasst und eine digital gesteuerte erste Phasensteuerschaltung (49, 51);
eine digital gesteuerte zweite Komponentenverarbeitungsschaltung, die so betrieben werden kann, dass sie die Amplitude und die Phase des zweiten Komponentensignals steuern kann, um ein zweites gesteuertes Komponentensignal zu erzeugen, wobei die zweite Komponentenverarbeitungsschaltung eine digital gesteuerte zweite Amplitudensteuerschaltung (45, 46) umfasst und eine digital gesteuerte zweite Phasensteuerschaltung (50, 53);
eine Kombinatorschaltung (55) für die Erzeugung eines Ausgangssignals durch die Kombination des ersten und zweiten gesteuerten Komponentensignals, wobei das Ausgangssignal eine amplituden- und phasengesteuerte Version des HF-Eingangssignals darstellt; und
einen digitalen Steuerkreis, der betrieben werden kann, um eine digitale Steuerung der ersten und zweiten Komponentenverarbeitungsschaltung in Reaktion auf eine gewünschte Amplituden- und Phasensteuerung des Eingangssignals auszuüben;
**dadurch gekennzeichnet, dass**
die erste Amplitudensteuerschaltung (45, 46) betrieben werden kann, um die Amplitude des ersten Komponentensignals zu steuern, um ein erstes amplitudengesteuertes Signal zu erzeugen;
die erste Phasensteuerschaltung (49, 51) betrieben werden kann, um die Phase des ersten amplitudengesteuerten Signals zu steuern, um das erste gesteuerte Komponentensignal zu erzeugen;
die zweite Amplitudensteuerschaltung (47, 48) betrieben werden kann, um die Amplitude des zweiten Komponentensignals zu steuern, um ein zweiten amplitudengesteuertes Signal zu erzeugen;
die zweite Phasensteuerschaltung (50, 53) betrieben werden kann, um die Phase des zweiten amplitudengesteuerten Signals zu steuern, um das zweite gesteuerte Komponentensignal zu erzeugen; und
der digitale Steuerkreis betrieben werden kann, um die Steuerung der Amplituden- und Phasensteuerkreise in Reaktion auf die gewünschte Amplitudenund Phasensteuerung des Eingangssignals auszuüben, indem an jede der Amplituden- und Phasensteuerkreise vorher festgelegte digitale Steuerinformationen geliefert werden, die mit der gewünschten Amplituden- und Phasensteuerung des Eingangssignals übereinstimmen.

2. Hochfrequenzsteuergerät nach Anspruch 1, bei dem die erste Phasensteuerschaltung eine erste Signalteilerschaltung (49) umfasst, die betrieben werden kann, um das erste amplitudengesteuerte Signal in ein erstes und ein zweites geteiltes Signal aufzuteilen, die entgegengesetzte Phasen aufweisen, und einen digital gesteuerten ersten Schalterstromkreis (51), der eines des ersten und zweiten geteilten Signals als erstes gesteuertes Komponentensignal auswählt; und bei dem die zweite Phasensteuerschaltung eine zweite Signalteilerschaltung (50) umfasst, die betrieben werden kann, um das zweite amplitudengesteuerte Signal in ein drittes und ein viertes geteiltes Signal aufzuteilen, die entgegengesetzte Phasen aufweisen, und einen digital gesteuerten zweiten Schalterstromkreis (53), der eines des dritten und vierten geteilten Signals als zweites gesteuertes Komponentensignal auswählt.

3. Hochfrequenzsteuergerät nach Anspruch 1 oder Anspruch 2, das eine vorbereitende Amplitudensteuerschaltung (41) umfasst, um die Amplitude des HF-Eingangssignals zu steuern, um ein gedämpftes HF-Eingangssignal zu erzeugen, das an einen Eingang der Eingangsteilerschaltung (43) geliefert wird.

4. Hochfrequenzsteuergerät nach einem der Ansprüche 1 bis 3, bei dem die erste und zweite Amplitudensteuerschaltung jeweils einen digital gesteuerten Dämpfer (45, 46, 47, 48) umfassen.

5. Hochfrequenzsteuergerät nach einem der Ansprüche 2 bis 4, bei dem die Eingangsteilerschaltung (43) einen phasengleichen Leistungsteiler umfasst, bei dem die erste und die zweite Phasensteuerschaltung (49, 50) jeweils einen 180°-Richtkoppler umfassen, und bei dem die Kombinatorschaltung (55) einen 90°-Richtkoppler umfasst.

6. Hochfrequenzsteuergerät nach Anspruch 5, der einen digital gesteuerten dritten Schalterstromkreis (56) umfasst, der an den Ausgang des 90°-Richtkopplers gekoppelt ist.

7. Hochfrequenzsteuergerät nach einem der Ansprüche 4 bis 6, bei dem die vorbereitende Amplitudensteuerschaltung (41) einen digital gesteuerten Dämpfer umfasst, der einen Bereich von 31 dB hat und in Schritten von 1 dB dämpft, und bei dem die digital gesteuerten Dämpfer (45, 46, 47, 48) der ersten und zweiten Amplitudensteuerschaltung jeweils zwei in Reihe gekoppelte Dämpfer umfassen, die jeweils einen Bereich von 15,5 dB haben und jeweils in Schritten von 0,5 dB dämpfen.

## Revendications

1. Dispositif de commande RF pour commander à la fois l'amplitude et la phase d'un signal d'entrée RF, comprenant :
un circuit diviseur d'entrée (43) apte à diviser le signal d'entrée RF en premier et second signaux de composant ;
un premier circuit de traitement numériquement commandé de composant, apte à commander l'amplitude et la phase du premier signal de composant, de manière à engendrer un premier signal commandé de composant, ledit premier circuit de traitement de composant comprenant un premier circuit de commande d'amplitude numériquement commandé (45, 46) et un premier circuit de commande de phase numériquement commandé (49, 51) ;
un second circuit de traitement numériquement commandé de composant apte à commander l'amplitude et la phase du second signal de composant, de manière à engendrer un second signal commandé de composant, ledit second circuit de traitement de composant comprenant un second circuit de commande d'amplitude numériquement commandé (47, 48) et un second circuit de commande de phase numériquement commandé (50, 53) ;
un circuit mélangeur (55) pour engendrer un signal de sortie en mélangeant les premier et second signaux commandés de composant, le signal de sortie étant une version commandée d'amplitude et de phase du signal d'entrée RF ; et un circuit de commande numérique apte à effectuer la commande numérique desdits premier et second circuits de traitement de composant en réaction à une commande désirée d'amplitude et de phase pour le signal d'entrée ;
**caractérisé en ce que** :
ledit premier circuit de commande d'amplitude (45, 46) est apte à commander l'amplitude du premier signal de composant, de manière à engendrer un premier signal commandé d'amplitude ;
ledit premier circuit de commande de phase (49, 51) est apte à commander la phase du premier signal commandé d'amplitude de manière à engendrer ledit premier signal commandé de composant ;
ledit second circuit de commande d'amplitude (47, 48) est apte à commander l'amplitude du second signal de composant, de manière à engendrer un second signal commandé d'amplitude ;
ledit second circuit de commande de phase (50, 53) est apte à commander la phase du second signal commandé d'amplitude de manière à engendrer ledit second signal commandé de composant ;
et ledit second circuit de commande de phase (50, 53) est apte à commander effectivement lesdits circuits de commande d'amplitude et de phase, en réaction à ladite commande désirée d'amplitude et de phase pour le signal d'entrée, en fournissant à chacun desdits circuits de commande d'amplitude et de phase, une information prédéterminée de commande numérique qui correspond à la commande désirée d'amplitude et de phase pour le signal d'entrée.

2. Dispositif de commande RF selon la revendication 1, dans lequel ledit premier circuit de commande de phase inclut un premier circuit diviseur du signal (49) apte à diviser le premier signal commandé d'amplitude en premier et second signaux divisés qui sont de phase opposée, et un premier circuit d'interrupteur numériquement commandé (51) pour sélectionner l'un des premier et second signaux divisés pour être le premier signal commandé de composant ; et dans lequel ledit second circuit de commande de phase inclut un second circuit diviseur du signal (50) apte à diviser le second signal commandé d'amplitude en troisième et quatrième signaux divisés qui sont de phase opposée, et un second circuit d'interrupteur numériquement commandé (53) pour sélectionner l'un des troisième et quatrième signaux divisés pour être le second signal commandé de composant.

3. Dispositif de commande RF selon la revendication 1 ou la revendication 2, comprenant un circuit de commande d'amplitude préliminaire (41) pour commander l'amplitude du signal d'entrée RF de manière à engendrer un signal d'entrée RF atténué fourni à une entrée du circuit diviseur d'entrée (43).

4. Dispositif de commande RF selon l'une quelconque des revendications 1 à 3, dans lequel lesdits premier et second circuits de commande d'amplitude comprennent chacun un atténuateur numériquement commandé (45, 46, 47, 48).

5. Dispositif de commande RF selon l'une quelconque des revendications 2 à 4, dans lequel ledit circuit diviseur d'entrée (43) comprend un diviseur de puissance en phase, dans lequel lesdits premier et second circuits diviseurs de signal (49, 50) comprennent chacun un hybride 180°, et dans lequel ledit circuit mélangeur (55) comprend un hybride 90°.

6. Dispositif de commande RF selon la revendication 5, comprenant un troisième circuit d'interrupteur numériquement commandé (56) accouplé à la sortie dudit hybride 90°.

7. Dispositif de commande RF selon l'une quelconque des revendications 4 à 6, dans lequel ledit circuit de commande d'amplitude préliminaire (41) comprend un atténuateur numériquement commandé ayant une gamme de 31 dB et atténuant par pas de 1 dB, et dans lequel lesdits atténuateurs numériquement commandés (45, 46, 47, 48) desdits premier et second circuits de commande d'amplitude comprennent chacun deux atténuateurs accouplés en série qui ont chacun une gamme de 15,5 dB et atténuent chacun en pas de 0,5 dB.
